# EUROPÄISCHE PATENTSCHRIFT

(11) **EP 0 683 967 B1**
(45) Veröffentlichungstag und Bekanntmachung des Hinweises auf die Patenterteilung: **18.09.1996**
(21) Anmeldenummer: 94904960.5
(22) Anmeldetag: 25.01.1994
(51) Int. Cl.: H05K 5/00, H05K 7/20, H01L 23/40

(54) **GEHÄUSE FÜR EINE ELEKTRONISCHE SCHALTUNG**
HOUSING FOR AN ELECTRONIC CIRCUIT
BOITIER POUR CIRCUIT ELECTRONIQUE

(30) Priorität: 11.02.1993 DE 4304050
(43) Veröffentlichungstag der Anmeldung: 29.11.1995
(73) Patentinhaber: ROBERT BOSCH GMBH, 70442 Stuttgart (DE)
(72) Erfinder: JAKOB, Gert, D-70378 Stuttgart (DE); HUSSMANN, Dieter, D-71711 Hemmingen (DE); SUTTER, Thomas, D-71739 Oberriexingen (DE); ZIMMERMANN, Joachim, D-71701 Schwieberdingen (DE); KARR, Dieter, D-5233 Tiefenbronn (DE)
(86) Internationale Anmeldenummer: DE9400056
(87) Internationale Veröffentlichungsnummer: WO9418813

(56) Entgegenhaltungen:
- WO-A-92/17904
- DE-U- 9 105 034
- IBM TECHNICAL DISCLOSURE BULLETIN, Bd.33, Nr.3A, 1. August 1990, NEW YORK US Seiten 47 - 48, XP000123848 'Module clamping device'

## Beschreibung

### Stand der Technik

Die Erfindung geht aus von einem Gehäuse für eine elektronische Schaltung, insbesondere für eine Steuerelektronik eines Kraftfahrzeuges, nach der Gattung des Hauptanspruchs. Ein derartiges Gehäuse ist beispielsweise aus dem DE-GM 90 07 236 bekannt. In dieses Gehäuse wird eine Leiterplatte mit elektronischen Bauelementen eingeschoben, an deren Rand ein Kühlrahmen mit etwa senkrecht abstehenden Kühlabschnitten befestigt ist. An diesen Kühlabschnitten liegen Leistungsbauelemente zur Wärmeableitung an und sind durch Federelemente an dieses gepreßt. Ein derartiges Gehäuse ist relativ aufwendig, da entsprechende Führungen für den Kühlrahmen vorgesehen sind. Darüberhinaus sind die Wärmeableitwege von den zu kühlenden Leistungsbauelementen über die Kühlabschnitte, den Kühlrahmen und das Gehäuse an die Umgebung relativ lang, so daß hohe Wärmemengen oftmals nur unzureichend abgeleitet werden können.

### Vorteile der Erfindung

Das im Anspruch 1 beauspruchte Gehäuse für eine elektronische Schaltung hat demgegenüber den Vorteil, daß das Gehäuse sehr einfach aufgebaut ist und daß die Wärmeableitwege von den an den Kühlabschnitten angebrachten Bauelementen sehr kurz sind. Darüberhinaus läßt sich ein derartiges Gehäuse aus einfachen gestanzten Blechteilen kostengünstig herstellen.

Weitere Vorteile und vorteilhafte Weiterbildungen der Erfindung ergeben sich aus den Unteransprüchen und der Beschreibung.

### Zeichnung

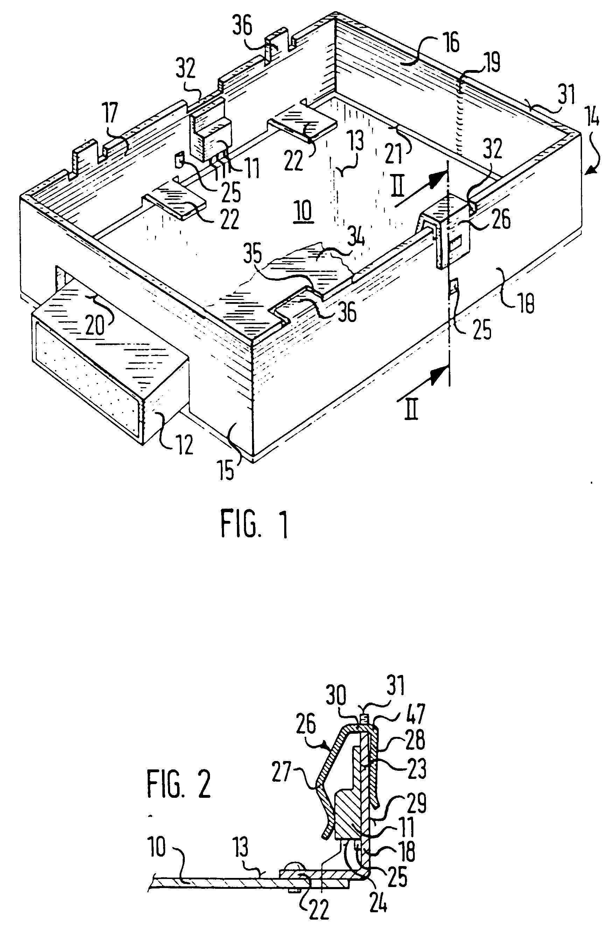

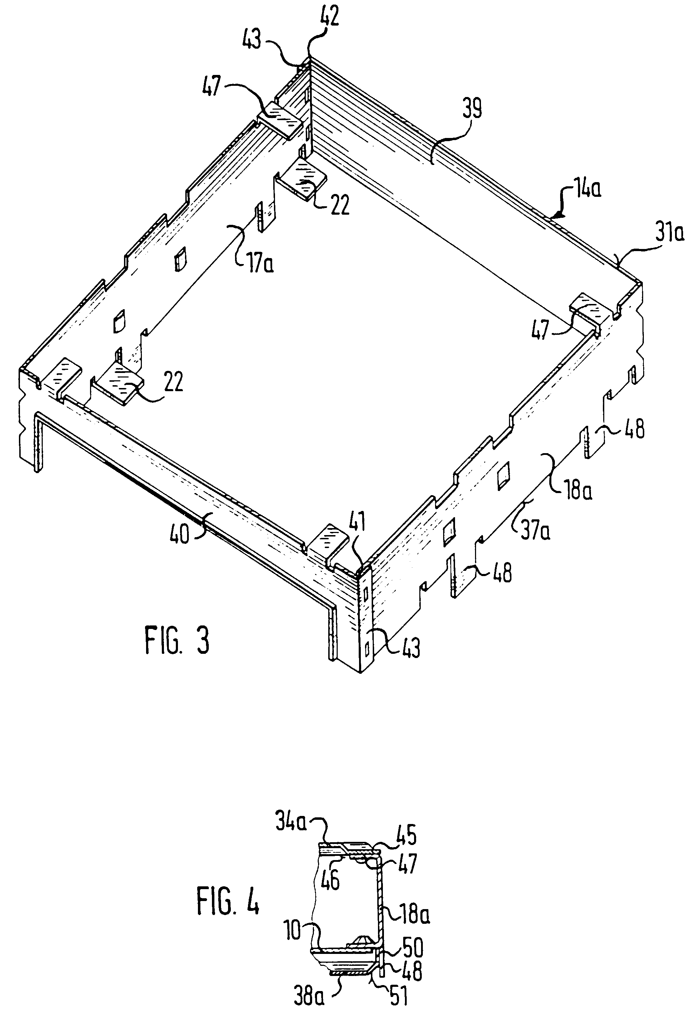

Ausführungsbeispiele der Erfindung sind in der nachfolgenden Beschreibung und Zeichnung näher erläutert. Letztere zeigt in Figur 1 eine perspektivische Darstellung einer Leiterplatte mit einem Kühlrahmen. Figur 2 zeigt einen Schnitt durch einen bestückten Kühlabschnitt längs II-II nach Figur 1. Die Figur 3 zeigt eine perspektivische Darstellung einer abgewandelten Ausführung des Kühlrahmens. Die Figur 4 zeigt ein nur teilweise dargestelltes, durch Deckel und Bodenteil verschlossenes Gehäuse, teilweise im Schnitt.

### Beschreibung der Ausführungsbeispiele

In Figur 1 ist mit 10 eine an sich bekannte Leiterplatte bezeichnet, die eine nicht näher dargestellte elektronische Schaltung trägt. Zu dieser Schaltung gehören elektronische Bauelemente 11, zum Beispiel Leistungstransistoren, die im Betrieb abzuleitende Wärme produzieren. An einer Stirnseite der Leiterplatte 10 ist eine Steckerleiste 12 angebracht, die zur Kontaktierung der elektronischen Schaltung dient.

Auf die Oberseite 13 der Leiterplatte 10 ist ein etwa rechteckiger Kühlrahmen 14 aufgesetzt. Dieser besteht im wesentlichen aus einem langgestreckten, rechteckigen Blechstreifen, der viermal etwa rechtwinklig abgebogen ist. Damit wird ein in sich geschlossener rechteckiger Rahmen mit Vorderseite 15, Rückseite 16 und zwei Seitenstreifen 17 bzw. 18 gebildet. Die beiden Enden des Blechstreifens stoßen im Bereich der Rückseite 16 aneinander und sind dort durch eine Schweißnaht bzw. Lötnaht 19 miteinander verbunden. Im Bereich der Vorderseite 15 hat der Kühlrahmen 14 eine etwa rechteckige Ausnehmung 20 zur Durchführung der Steckerleiste 12. An seiner der Leiterplatte 10 zugewandten Unterseite 21 hat der Kühlrahmen 14 im Bereich der Seitenstreifen 17 bzw. 18 mehrere etwa rechtwinklig nach innen abgebogene Befestigungslaschen 22, die auf der Leiterplatte 10 aufliegen. Im Bereich dieser Befestigungslaschen 22 sind der Kühlrahmen 14 und die Leiterplatte 10 miteinander verbunden, zum Beispiel vernietet (siehe beispielsweise Figur 2 und 4). Die Abmessungen des Kühlrahmens 14 sind so gewählt, daß seine Breite und Länge jeweils etwas größer als die der Leiterplatte 10 sind, so daß sich die Leiterplatte im Inneren der durch den Kühlrahmen 14 begrenzten Fläche befindet. Zusätzlich zu den hier beschriebenen und dargestellten Befestigungslaschen 22 können diese auch im Bereich der Vorderseite 15 und Rückseite 16 des Kühlrahmens 14 angebracht sein.

Die Bauelemente 11 (Leistungsbauelemente), die sich im Betrieb der elektronischen Schaltung erhitzen, sind am Rand der Leiterplatte 10 im Bereich der Seitenstreifen 17 und 18 des Kühlrahmens 14 angeordnet und stehen etwa senkrecht von der Leiterplatte 10 ab. Darüberhinaus können derartige Bauelemente 11 auch im Bereich der Vorderseite 15 und der Rückseite 16 des Kühlrahmens 14 angeordnet sein. Die Bauelemente 11 liegen mit ihren Rückseiten 23 am Kühlrahmen 14 bzw. an den Seitenstreifen 17 oder 18 an. Mit ihren Unterseiten 24 liegen sie auf einem Vorsprung 25 auf, der durch Stanzen aus dem Seitenstreifen 17 bzw. 18 nach innen zur Leiterplatte 10 hin eingebogen ist. Die Bauelemente 11 werden durch ein Federelement 26 an den Kühlrahmen 14 gepreßt. Dieses Federelement 26 ist etwa U-förmig, so daß ein Federschenkel 27 am Bauelement 11 anliegt, während der andere Federschenkel 28 an der Außenseite 29 des Seitenstreifens 17 bzw. 18 (Kühlrahmen 14) anliegt. Das Basisteil 30 des Federelements 26 umfaßt die Oberseite 31 des Kühlrahmens 14 bzw. der Seitenstreifen 17 bzw. 18 und befindet sich in einer nach oben offenen Ausnehmung 32 des Kühlrahmens 14. Die Abmessungen dieser Ausnehmung 32 (Breite bzw. Tiefe) sind jeweils etwas größer als die Breite bzw. Dicke des Basisteils 30.

Auf der Oberseite 31 des Kühlrahmens 14 liegt ein etwa rechteckiger Deckel 34 auf, dessen Abmessungen etwa den Außenabmessungen des Kühlrahmens 14 entspricht. Der Deckel 34 hat im Bereich der Seitenstreifen 17 bzw. 18 mehrere eingedrückte Vertiefungen 35, von denen in Figur 1 nur eine dargestellt ist. Diese Vertiefungen 35 sind so nach unten bzw. innen eingedrückt, daß der Deckel 34 auf der Oberseite 31 des Kühlrahmens aufliegt, und daß die Vertiefungen sich im Inneren des Kühlrahmens 14 befinden. Im Bereich dieser Vertiefungen 35 sind an der Oberseite 31 des Kühlrahmens 14 nach oben weisende Befestigungslaschen 36 ausgebildet, die zur Halterung des Deckels etwa rechtwinklig nach innen in die Vertiefungen 35 abgebogen sind. Die Tiefe und Breite bzw. Länge der Vertiefungen 35 sind entsprechend an die Dicke, Breite bzw. Länge der Befestigungslaschen 36 angepaßt. Die Unterseite 21 des Kühlrahmens 14 sowie die Leiterplatte 10 werden durch ein nicht dargestelltes wannenförmiges Bodenteil abgedeckt, dessen Seitenwände den unteren Teil des Kühlrahmens 14 umfassen. Durch das Bodenteil, den Kühlrahmen 14 und den Deckel 34 werden somit ein geschlossenes, undichtes Gehäuse zur Aufnahme der Leiterplatte 10 und der elektrischen Bauelemente 11 gebildet.

In den Figuren 3 und 4 werden eine abgewandelte Ausbildungsform des Kühlrahmens 14a sowie eine abgewandelte Form des Deckels 34a und ein Bodenteil 38a dargestellt. Der Kühlrahmen 14a besteht aus zwei Kühlwinkeln 39 bzw. 40, die an jeweils einer gegenüberliegenden Ecke 41 bzw. 42 miteinander verbunden sind. Dazu ist jeweils ein schmaler Randstreifen 43 eines der Kühlwinkel 39 bzw. 40 rechtwinklig abgebogen und mit dem freien Ende des anderen Kühlwinkels 40 bzw. 39 verbunden, zum Beispiel vernietet. Auf der Oberseite 31a des Kühlrahmens 14a liegt ein etwa wannenförmiger Deckel 34a auf, der im Bereich der Seitenstreifen 17a bzw. 18a mehrere eingesenkte Vertiefungen 45 aufweist. Die Unterseite der Vertiefungen 45 liegt jeweils auf einer nach innen vom Seitenstreifen 17a bzw. 18a abgebogenen Befestigungslasche 47 auf. Durch Vernieten im Bereich der Vertiefungen 45 bzw. der Befestigungslaschen 47 sind der Deckel 34a und der Kühlrahmen 14a miteinander verbunden. An der Unterseite 37a des Kühlrahmens 14a sind mehrere Befestigungsstreifen 48 ausgebildet. Neben den Befestigungsstreifen 48 hat der Kühlrahmen 14a - wie der Kühlrahmen 14 - mehrere nach innen weisende Befestigungslaschen 22 zur Auflage und Befestigung auf der Leiterplatte 10.

Die Unterseite der Leiterplatte 10 bzw. die Unterseite des Kühlrahmens 14 wird durch ein etwa wannenförmiges Bodenteil 38a abgedeckt, dessen Seitenwände 50 von den Befestigungslaschen 48 umfaßt werden. Diese werden um den Rand 51 des Bodenteils 38a herumgebogen, so daß dieses mit dem Kühlrahmen 14a verbunden ist. Zur Aufnahme dieser Befestigungsstreifen 48 können im Bodenteil 38a nicht dargestellte Vertiefungen ausgebildet sein, die - wie beim Deckel 34a - zur Aufnahme der umgebogenen Befestigungsstreifen 48 dienen.

Durch die dargestellten und beschriebenen Kühlrahmen 14 bzw. 14a und die mit diesen verbundenen Deckel 34 bzw. 34a und Bodenteile 38a werden in sich geschlossene, undichte Gehäuse geschaffen, die aus herkömmlichen Blechen gestanzt werden können. Das Verbinden des Kühlrahmens mit dem Deckel bzw. Bodenteil erfolgt mit einfachen Befestigungslaschen bzw. Befestigungsstreifen, die durch Stanzen am Rahmenteil 14 bzw. 14a ausgebildet sind. Durch das so beschriebene Gehäuse werden darüberhinaus sehr kurze Wärmeableitwege geschaffen, da die sich erwärmenden Bauelemente 11 direkt an der Außenwand des Gehäuses anliegen. Die Federelemente 26 zum Anpressen der Bauelemente 11 werden vor dem Verschließen des Gehäuses mit dem Deckel über den Rand des Kühlrahmens geführt. Durch den abschließenden Deckel wird damit einerseits das Gehäuse verschlossen, zusätzlich werden die Federelemente 26 gegen Abschieben gesichert.

## Patentansprüche

1. Gehäuse für eine elektronische Schaltung, insbesondere für eine Steuergeräteelektronik eines Kraftfahrzeuges, mit einem Kühlrahmen (14, 14a), an dem eine die elektronische Schaltung aufweisende Leiterplatte (10) befestigt ist, und der mindestens einen etwa senkrecht zur Leiterplatte (10) verlaufenden Kühlabschnitt (17, 17a, 18, 18a) aufweist, mit dem mit der Leiterplatte (10) elektrisch leitend verbundene elektronische Bauelemente (11) der Schaltung mittels mindestens eines Federelementes (26), welches das Bauelement (11) und den Kühlabschnitt (17, 17a, 18, 18a) übergreift, wärmeleitend verbunden ist, wobei der Kühlrahmen (14, 14a) gleichzeitig eine Außenwand des Gehäuses ist, wobei im Gehäuse Ausnehmungen (32) für das Federelement (26) angeordnet sind und wobei der Kühlrahmen (14, 14a) Befestigungslaschen (22) hat, mit denen der Kühlrahmen (14, 14a) auf der Leiterplatte (10) aufliegt und mit der Leiterplatte (10) verbunden ist.

2. Gehäuse für eine elektronische Schaltung nach Anspruch 1, dadurch gekennzeichnet, daß die Ausnehmungen (32) an der Oberseite (31) des Kühlrahmens (14) verlaufen.

3. Gehäuse für eine elektronische Schaltung nach Anspruch 1 oder 2, dadurch gekennzeichnet, daß das Federelement (26) etwa U-förmig ist und mit seinem Basisteil (30) im Bereich der Ausnehmung (32) so angeordnet ist, daß ein Federschenkel (27) am Bauelement (11) anliegt und der andere Federschenkel (28) an der Außenseite des Gehäuses anliegt.

4. Gehäuse für eine elektronische Schaltung nach einem der Ansprüche 1 bis 3, dadurch gekennzeichnet, daß der Kühlrahmen (14, 14a) etwa rechteckig ist, und auf der Oberseite (13) der Leiterplatte (10) befestigt ist.

5. Gehäuse für eine elektronische Schaltung nach einem der Ansprüche 1 bis 4, dadurch gekennzeichnet, daß der Kühlrahmen (14, 14a) etwa senkrecht nach innen ragende Befestigungslaschen (22) aufweist, die auf der Leiterplatte (10) aufliegen.

6. Gehäuse für eine elektronische Schaltung nach einem der Ansprüche 1 bis 5, dadurch gekennzeichnet, daß der Kühlrahmen (14, 14a) an einer Stirnseite (15) eine Öffnung (20) zur Durchführung einer mit der Leiterplatte (10) verbundenen Steckerleiste (12) aufweist.

7. Gehäuse für eine elektronische Schaltung nach einem der Ansprüche 1 bis 6, dadurch gekennzeichnet, daß auf dem Kühlrahmen (14, 14a) ein Deckel (34) aufliegt.

8. Gehäuse für eine elektronische Schaltung nach einem der Ansprüche 1 bis 7, dadurch gekennzeichnet, daß die Unterseite der Leiterplatte (10) durch ein etwa wannenförmiges Bodenteil (38a) abgedeckt ist, dessen Seitenwände (50) mit dem Kühlrahmen (14, 14a) verbunden sind.

9. Gehäuse für eine elektronische Schaltung nach einem der Ansprüche 1 bis 8, dadurch gekennzeichnet, daß der Kühlrahmen (14, 14a) aus einem mehrfach abgewinkelten Stanzblech besteht.

10. Gehäuse für eine elektronische Schaltung nach einem der Ansprüche 1 bis 9, dadurch gekennzeichnet, daß der Kühlrahmen (14, 14a) ein geschlossenes Rechteck bildet.

## Claims

1. Housing for an electronic circuit, in particular for an electronic system of the control device of a motor vehicle, having a cooling frame (14, 14a) to which a printed circuit board (10) which has the electronic circuit is attached, and which has at least one cooling section (17, 17a, 18, 18a) which runs approximately perpendicular to the printed circuit board (10) and to which electronic components (11) of the circuit, which are connected in an electrically conductive way to the printed circuit board (10), are connected in a heat-conducting manner by means of at least one spring element (26) which engages over the component (11) and the cooling section (17, 17a, 18, 18a), the cooling frame (14, 14a) simultaneously being an outer wall of the housing, cutouts (32) for the spring element (22) being arranged in the housing, and the cooling frame (14, 14a) having attachment clips (22) with which the cooling frame (14, 14a) rests on the printed circuit board (10) and is connected to the printed circuit board (10).

2. Housing for an electronic circuit according to Claim 1, characterized in that the cutouts (32) run on the upper side (31) of the cooling frame (14).

3. Housing for an electronic circuit according to Claim 1 or 2, characterized in that the spring element (26) is approximately U shaped and is arranged with its base part (30) in the region of the cutout (32) in such a way that one spring leg (27) is in contact with the component (11) and the other spring leg (28) is in contact with the outside of the housing.

4. Housing for an electronic circuit according to one of Claims 1 to 3, characterized in that the cooling frame (14, 14a) is approximately rectangular and is attached to the upper side (13) of the printed circuit board (10).

5. Housing for an electronic circuit according to one of Claims 1 to 4, characterized in that the cooling frame (14, 14a) has perpendicularly inward projecting attachment clips (22) which rest on the printed circuit board (10).

6. Housing for an electronic circuit according to one of Claims 1 to 5, characterized in that the cooling frame (14, 14a) has on one end side (15) an opening (20) for guiding through a multipoint connector (12) which is connected to the printed circuit board (10).

7. Housing for an electronic circuit according to one of Claims 1 to 6, characterized in that a cover (34) rests on the cooling frame (14, 14a).

8. Housing for an electronic circuit according to one of Claims 1 to 7, characterized in that the underside of the printed circuit board (10) is covered by an approximately tub-shaped base part (38a) whose side walls (50) are connected to the cooling frame (14, 14a).

9. Housing for an electronic circuit according to one of Claims 1 to 8, characterized in that the cooling frame (14, 14a) consists of a punched metal sheet bent a plurality of times.

10. Housing for an electronic circuit according to one of Claims 1 to 9, characterized in that the cooling frame (14, 14a) forms an enclosed rectangle.

## Revendications

1. Boîtier pour un circuit électronique, en particulier pour le système électronique de commande d'un véhicule à moteur, avec un cadre de refroidissement (14, 14a), sur lequel est fixée une carte imprimée (10) présentant ce circuit électronique, et qui présente au moins une section de refroidissement (17, 17a ; 18, 18a) s'étendant à peu près perpendiculairement par rapport à la carte imprimée (10), section de refroidissement à laquelle sont reliés de façon thermoconductrice des composants électroniques (11), reliés de façon électriquement conductrice à la carte imprimée (10), du circuit au moyen d'au moins un élément à ressort (26), qui enserre le composant (11) et la section de refroidissement (17, 17a ; 18, 18a), le cadre de refroidissement (14, 14a) constituant en même temps une paroi extérieure du boîtier, des évidements (32) pour l'élément à ressort (26) étant disposés dans le boîtier et le cadre de refroidissement (14, 14a) ayant des pattes de fixation (22), avec lesquelles le cadre de fixation (14, 14a) repose sur la carte imprimée (10) et est relié à la carte imprimée (10).

2. Boîtier pour un circuit électronique selon la revendication 1, caractérisé en ce que les évidements (32) s'étendent sur la face supérieure (31) du cadre de refroidissement (14).

3. Boîtier pour un circuit électronique selon la revendication 1 ou 2, caractérisé en ce que l'élément à ressort (26) a, à peu près la forme d'un U et est disposé par sa base (30) dans la zone de l'évidement (32) d'une manière telle qu'une aile du ressort (27) repose sur le composant (11) et que l'autre aile du ressort (28) repose sur la face extérieure du boîtier.

4. Boîtier pour un circuit électronique selon l'une des revendications 1 à 3, caractérisé en ce que le cadre de refroidissement (14, 14a) est à peu près rectangulaire et est fixé sur la face supérieure (13) de la carte imprimée (10).

5. Boîtier pour un circuit électronique selon l'une des revendications 1 à 4, caractérisé en ce que le cadre de refroidissement (14, 14a) présente des pattes de fixation (22) qui font saillie à peu près perpendiculairement vers l'intérieur, pattes qui reposent sur la carte imprimée (10).

6. Boîtier pour un circuit électronique selon l'une des revendications 1 à 5, caractérisé en ce que le cadre de refroidissement (14, 14a) présente une face frontale (15) un orifice (20) pour le passage d'une barrette d'enfichage (12) reliée à la carte imprimée (10).

7. Boîtier pour un circuit électronique selon l'une des revendications 1 à 6, caractérisé en ce qu'un couvercle (34) repose sur le cadre de refroidissement (14, 14a).

8. Boîtier pour un circuit électronique selon l'une des revendications 1 à 7, caractérisé en ce que la face inférieure de la carte imprimée (10) est recouverte par un fond, ayant à peu près la forme d'une cuvette (38a) dont les parois latérales (50) sont reliées au cadre de refroidissement (14, 14a).

9. Boîtier pour un circuit électronique selon l'une des revendications 1 à 8, caractérisé en ce que le cadre de refroidissement (14, 14a) consiste en une tôle repliée plusieurs fois par estampage.

10. Boîtier pour un circuit électronique selon l'une des revendications 1 à 9, caractérisé en ce que le cadre de refroidissement (14, 14a) forme un rectangle fermé.
